(19) Europäisches Patentamt
European Patent Office
Office européen des brevets

(11) **EP 3 196 943 A1**

(12) **EUROPEAN PATENT APPLICATION**

(43) Date of publication:
**26.07.2017 Bulletin 2017/30**

(51) Int Cl.:
*H01L 29/36* (2006.01)     *H01L 29/66* (2006.01)
*H01L 29/861* (2006.01)

(21) Application number: **16152366.7**

(22) Date of filing: **22.01.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ABB Technology AG**
**8050 Zürich (CH)**

(72) Inventors:
- **Papadopoulos, Charalampos**
  **5600 Lenzburg (CH)**
- **Rahimo, Munaf**
  **5619 Uezwil (CH)**
- **Matthias, Sven**
  **5600 Lenzburg (CH)**

(74) Representative: **ABB Patent Attorneys**
**C/o ABB Schweiz AG**
**Intellectual Property (CH-LC/IP)**
**Brown Boveri Strasse 6**
**5400 Baden (CH)**

(54) **BIPOLAR DIODE AND METHOD FOR MANUFACTURING SUCH A DIODE**

(57)     A manufacturing method for a bipolar diode (1) wherein:

(a) providing an (n-) doped wafer (10) having a first side (11) and a second side (12),

(b) applying a first p dopant (31) on the first side (11),

(c) creating an anode buffer layer (30) by diffusing the first dopant (31) into the wafer (10) at a first temperature up to a depth (32) between 15 and 30 $\mu$m,

(d) applying a second p dopant (34) on the first side (11),

(e) creating an anode shield layer (33) by diffusing the second dopant (34) into the wafer (10) at a second temperature, which is lower than the first temperature, and up to a depth (35) up to 3 $\mu$m,

(f) applying a third p dopant (37) on the first side (11), and

(g) creating the anode contact layer (36) by diffusing the third dopant (37) into the wafer (10) at a third temperature, which is lower than the second temperature, and up to a depth (38) up to 0.5 $\mu$m.

FIG 10

# Description

## Technical Field

The invention relates to the field of power electronics and more particularly to a method for manufacturing a bipolar diode according to claim 1 and to such a bipolar diode according to the preamble of claim 9.

## Background Art

A prior art diode comprises on a cathode side an (n-) doped drift layer and on an anode side opposite to the cathode side a p doped anode layer. On top of the p doped anode layer a metal layer which functions as an anode electrode is arranged. On the cathode side, a higher (n+) doped cathode layer is arranged. A metal layer in form of a cathode electrode is arranged on top of the (n+) doped cathode layer.

The anode layer may comprise a shallow, highly doped anode contact layer and a deeper, lower doped anode buffer layer.

The anode buffer layer can be optimized either for leakage current, for which a high doping concentration is needed in a low depth. Such a high doping concentration has the consequence that the doping concentration in a larger depth is also high. This is the consequence from using a single diffusion for the anode buffer layer. However, such a high doping concentration in great depths has disadvantages for the soft turn off of the device.

Therefore, other devices are made, which are optimized for soft turn off of the device, which requires a deep, but low doped anode buffer layer, which is achieved by having a low doping concentration in great depth, e.g. in around 15 $\mu$m depth. However, this can only be achieved by also lowering the doping concentration in lower depth (e.g. 5 $\mu$m), which value is again unfavourable for the leakage current.

Such devices may be created by implanting and diffusing a dopant for the anode buffer layer and afterwards implanting and diffusing a dopant for the anode contact layer.

With such prior art devices, it is not possible to influence the curvature of the doping concentration profile, and thus, it is not possible to optimize leakage current and softness simultaneously in one device.

Therefore, a method for manufacturing a power diode has been described in EP 2 535 940 A1, in which a dopant is implanted for the creation of the anode buffer layer, which dopant is then only partly diffused to a first depth. Then the same dopant type is implanted again in another step and diffused together with the first implanted dopant, so that an overlaid diffused anode buffer layer is created having a shallower doping concentration profile than the single diffusion anode buffer layer so that compared to the single diffused anode buffer diode, the anode buffer doping concentration can be kept lower for smaller depths and higher for larger depth, thereby improving leakage current and softness.

If the anode contact layer is made very thin, small manufacturing process parameters lead to a shift of the anode contact layer, which due to the high doping concentration of this layer, has leads to undesired variations in the device properties. A larger depth negatively influences the softness of the device.

## Disclosure of Invention

It is an object of the invention to provide a method for manufacturing a bipolar diode having better softness and less leakage current than achievable by prior art methods and a better controllable manufacturing method.

This object is achieved by a method for manufacturing a bipolar diode according to claim 1 and by a bipolar diode according to claim 9.

A method for manufacturing a bipolar diode is provided having a drift layer of a first conductivity type on a cathode side and an anode layer of a second conductivity type on an anode side opposite to the cathode side, which anode layer comprises an anode contact layer, an anode shield layer and an anode buffer layer. The method comprises the following manufacturing steps in the following order:

    (a) providing a wafer of the first conductivity type, which wafer has a first side and a second side opposite to the first side, wherein such part of the wafer of unamended doping concentration in the finalized diode forms the drift layer,

    (b) applying a first dopant of the second conductivity type to the wafer on the first side,

    (c) creating the anode buffer layer by diffusing the first dopant into the wafer at a first temperature up to an anode buffer layer depth, which is between 15 and 30 $\mu$m,

    (d) applying a second dopant of the second conductivity type to the wafer on the first side,

    (e) creating the anode shield layer by diffusing the second dopant into the wafer at a second temperature, which is lower than the first temperature, and up to an anode shield layer depth, which is up to 3 $\mu$m,

    (f) applying a third dopant of the second conductivity type to the wafer on the first side, and

    (g) creating the anode contact layer by diffusing the third dopant into the wafer at a third temperature, which is lower than the second temperature, and up to an anode contact layer depth, which is up to 0.5 $\mu$m,

wherein a maximum doping concentration of the anode contact layer is higher than a maximum doping concentration of the anode shield layer, which is higher than a maximum doping concentration of the anode buffer layer.

By the introduction of the anode shield layer between the highly doped anode contact layer and the lowly doped anode buffer layer (i.e. lower doped than the anode contact layer) with a maximum doping concentration, which is lower than the maximum doping concentration of the anode contact layer and higher than the maximum doping concentration of the anode buffer layer, the device gets less sensitive to manufacturing process variations, exemplarily at the steps of implantation or diffusion.

With the inventive method, it is possible to create a well-defined very shallow, but highly doped anode layer together with a low doped anode buffer layer with the anode shield layer in between. The rise of doping concentration of the anode layer can be tailored by the inventive method to achieve a high doping concentration level for a good contact to the anode electrode with a controlled decrease of the doping concentration in a short distance towards the low doping concentration of the anode buffer layer.

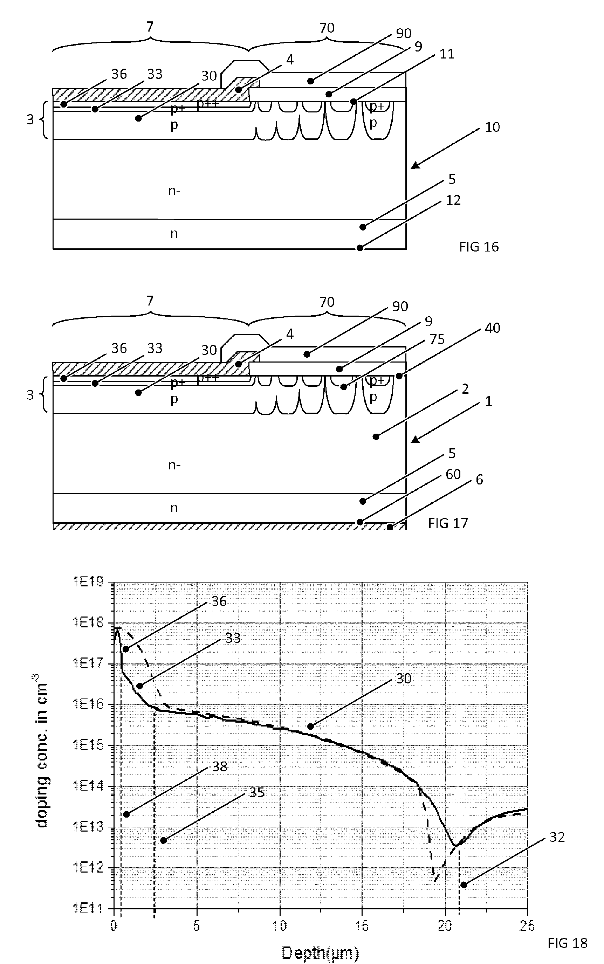

The safe operating area (SOA) capability is improved for operation of the diode at high temperatures due to the introduction of the shield anode layer due to allowing to introduce a very shallow, but highly doped anode contact layer, while keeping the doping concentration lower at medium depths (anode shield layer) compared to prior art devices (see FIG 18, the dashed line showing a doping concentration of a prior art diode and the continuous line showing a doping concentration of an inventive diode). The switching capacity can be improved by the shield anode layer and also the switching speed while maintaining the good softness properties. The higher doping concentration in lower depths (up to 5 $\mu$m) leads for the prior art devices to a decrease of softness at low currents, whereas with the inventive anode layer, the anode shield layer does not show such negative impact.

The inventive diode needs no local defect layer or reduced local lifetime control dose or energy due to the presence of the anode shield layer, which allows to have a high doping concentration in a narrow depth range and a controlled doping concentration reduction towards a lower value of the anode buffer layer, responsible for a high SOA. That means, the leakage current can be reduced by the introduction of the anode shield layer even without a defect layer.

For diodes having a passivation layer in a termination region and an anode layer, which consists of anode contact layer, anode shield layer and anode buffer layer in an inner region, which is electrically contacted by the anode electrode, and an anode layer, which consists of the anode shield layer and anode buffer layer in the termination region, the doping concentration in the termination region at the surface of the wafer is reduced compared to the inner region. This reduces the electric field in the termination region, and thereby the diode gets less sensitive to undesired surface ions in the termination region.

The inventive diode can advantageously be used as a free-wheeling or clamping diode in IGCT (Integrated gate commutated thyristor) or a free-wheeling diode in the IGBT (insulated gate bipolar transistor) applications.

Further exemplary embodiments of the inventive subject matter are disclosed in the dependent claims.

### Brief Description of Drawing

The subject matter of the invention will be explained in more detail in the following text with reference to the attached drawings, in which:

FIGs 1 to 9 show steps for manufacturing an inventive semiconductor device;

FIG 10 shows a cross sectional view on an inventive diode;

FIG 11 to 16 show steps for manufacturing another inventive semiconductor device;

FIG 17 shows a cross sectional view on an inventive diode; and

FIG 18 shows doping profiles for an inventive anode layer and an anode layer according to a prior art diode.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

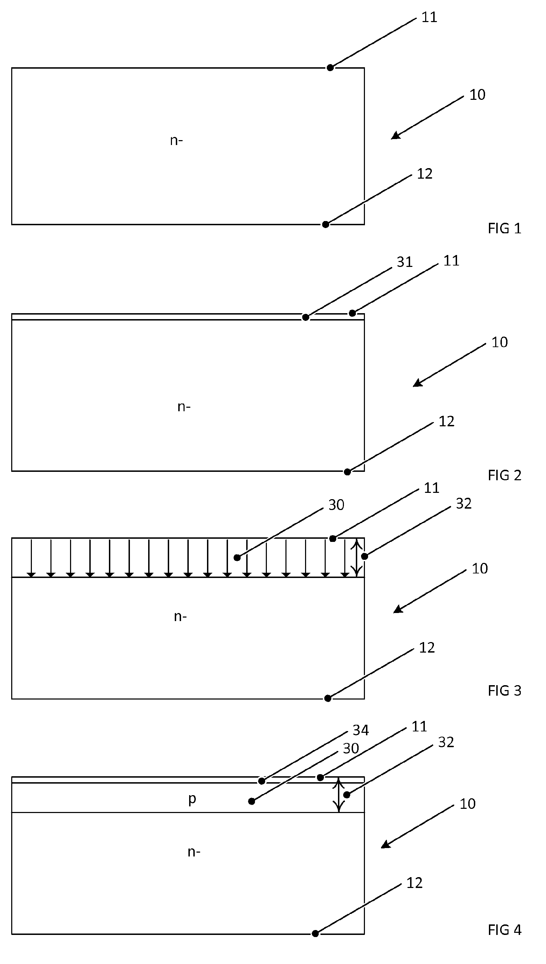

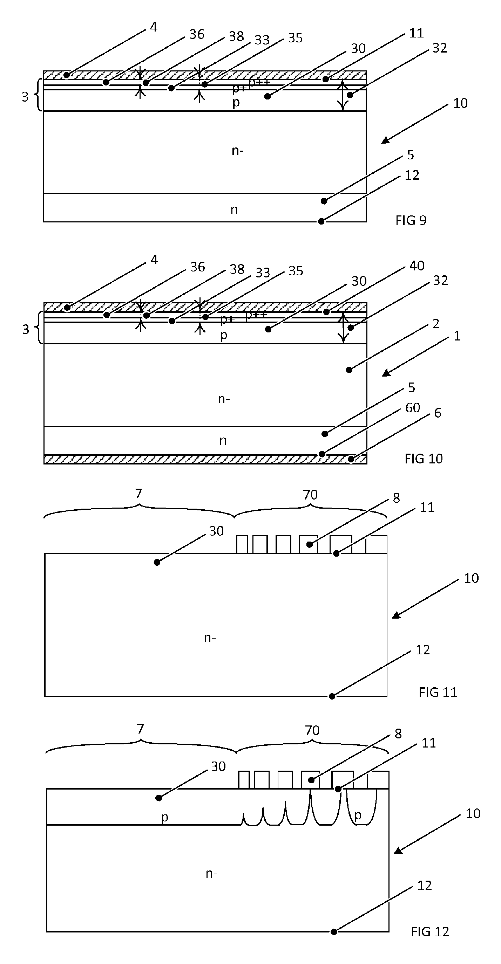

In the FIGs 1 to 10 a method for manufacturing an inventive bipolar diode 1 is shown, FIG 10 showing the finalized diode. The diode 1 has drift layer 2 of a first conductivity type on a cathode side 60 and an anode layer 3 of a second conductivity type, which is different from the first conductivity type, on an anode side 40 opposite to the cathode side 60. The anode layer 3 comprises an anode contact layer 36, an anode shield layer 33 and an anode buffer layer 30. In the manufacturing method, shown in the figures 1 to 10, the drift layer is (n-) doped and the anode layer 3 is p doped. In another embodiment, the conductivity types are switched, i.e. all layers of the first conductivity type are p type (e.g. drift layer 2 and all layers of the second conductivity type are n type (e.g. anode layer 3).

The method comprises the following manufacturing steps in the following order:

(a) providing a low (n-) doped wafer 10, which wafer 10 has a first side 11 and a second side 12 opposite to the first side 11, wherein such part of the wafer of unamended doping concentration in the finalized diode forms the drift layer 2 (FIG 1),

(b) applying a first p dopant 31 of the second conductivity type to the wafer 10 on the first side 11 (FIG 2),

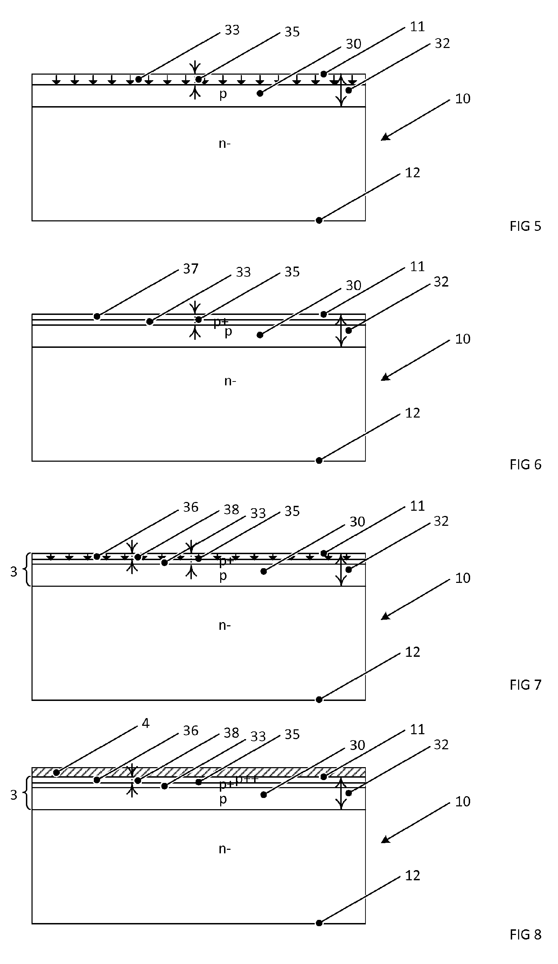

(c) creating the anode buffer layer 30 by diffusing the first dopant 31 into the wafer 10 at a first temperature up to an anode buffer layer depth 32, which is between 15 and 30 $\mu$m (FIG 3); the arrows in FIG 3 indicate the diffusion process (also present in the figures 5 and 7);

(d) applying a second p dopant 34 to the wafer 10 on the first side 11 (FIG 4),

(e) creating the anode shield layer 33 by diffusing the second dopant 34 into the wafer 10 at a second temperature, which is lower than the first temperature, and up to an anode shield layer depth 35, which is up to 3 $\mu$m (FIG 5),

(f) applying a third p dopant 37 to the wafer 10 on the first side 11 (FIG 6), and

(g) creating the anode contact layer 36 by diffusing the third dopant 37 into the wafer 10 at a third temperature, which is lower than the second temperature, and up to an anode contact layer depth 38, which is up to 0.5 $\mu$m (FIG 7),

wherein a maximum doping concentration of the anode contact layer 36 is higher than a maximum doping concentration of the anode shield layer 33, which is higher than a maximum doping concentration of the anode buffer layer 30.

In the finalized diode, the first side 11 corresponds to the anode side 40 and the second side 12 corresponds to the cathode side 60.

the term "low (n-) doped" shall be understood as a relative doping concentration, which is lower than a higher doping concentration of layers like the higher doped anode buffer layer 30 or the higher doped cathode layer 5.

In step (c) the first dopant is diffused to its final depth, i.e. the anode buffer layer depth 32. In the following diffusions (step (e) and (g)), lower temperatures are applied, by which the first dopant 31 is not or at least negligibly deeper diffused. That shall means that by the later diffusions at lower temperatures (which may be combined with shorter diffusion times) the first dopant 31 may be diffused not by more than 5 % of the first diffusion depth or by less than 2 % or even less than 1 %. If the first diffusion is deeper (e.g. more than 20 $\mu$m) such later diffusion will enlarge the diffusion depth to a smaller extent (e.g. less than 1 %) than for a smaller first diffusion depth (e.g. at least 15 $\mu$m), at which a later diffusion may lead to depth increase of up to 2 %. The layer depths are measured from the first side 11 (anode side 40), which is the wafer surface on such side at which the anode layer is created.

The maximum doping concentration of the anode contact layer 36 shall be the absolute maximum doping concentration of the anode layer 3. It lies close to the first side 11 (anode side 40). The maximum doping concentration of the anode shield layer 33 shall be measured at the crossing point of the anode shield layer 33 to the anode contact layer 36 and the maximum doping concentration of the anode buffer layer 30 is measured at the crossing point of the anode buffer layer 30 to the anode shield layer 33.

The crossing point between the anode contact layer 36 and the anode shield layer 33 shall be defined by a gradient $\frac{dN}{dx}$ (N being the p doping concentration N and x being the depth from the first side 11) having a local minimum at the crossing point. The same applies for the crossing point of the anode shield layer 33 and the anode buffer layer 30.

In step (b) such amount of the first dopant 31 may be applied and in step (c) the first dopant 31 may be diffused such that the anode buffer layer 30 has the maximum doping concentration below $2.0*10^{16}$ cm$^{-3}$ at the crossing point to the anode shield layer 33. A lower limit for the maximum doping concentration of the anode buffer layer 30 may be $5.0*10^{15}$ cm$^{-3}$ or $1.0*10^{16}$ cm$^{-3}$ depending on the application.

In step (d) such amount of the second dopant 34 may be applied and in step (e) the second dopant 34 may be diffused such that the anode shield layer 33 has the maximum doping concentration between $2.0*10^{16}$ cm$^{-3}$ and $1.0*10^{17}$ cm$^{-3}$ at the crossing point to the anode contact layer 36.

In step (f) such amount of the third dopant 37 may be applied and in step (g) the third dopant 37 may be diffused such that the anode contact layer 36 has the maximum doping concentration of at least $1.0*10^{17}$ cm$^{-3}$. The anode contact layer 36 may have an upper limit of the maximum doping concentration of $5.0*10^{17}$ cm$^{-3}$. With such an upper limit good softness properties may be achieved.

The first temperature applied in step (c) for the diffusion of the first dopant 31 (i.e. for the anode buffer layer 30) is higher than the second temperature applied in step (e) for the diffusion of the second dopant 34 (i.e. for the anode shield layer 33), which again is higher than the third temperature applied in step (g) for the diffusion of the third dopant 37 (i.e. anode contact layer 36). Additionally in an exemplary embodiment, also the diffusion times may be chosen such that the layer depth are achieved. Exemplarily, the diffusion time for the first dopant 31 in step (c) is longer than a diffusion time for the second dopant 34 in step (e), which is longer than a diffusion time for the third dopant 37 in step (g).

In an exemplary embodiment, in step (b) and (d) and (f) the first, second and third dopant 31, 34, 37 are of the same particle sort. Alternatively, different particles may be chosen as first second and/or third dopant 31, 34, 37. For example, B, Al or Ga ions may be used as first, second and/or third dopant 31, 34, 37.

The first, second and/or third dopant 31, 34, 37 for the creation of the anode buffer layer 30, anode shield layer 33 and/or anode contact layer 36 can be applied by surface deposition or by ion implantation. Depending of the method for applying the dopant onto the wafer surface, the dopant 31, 34, 37 is deposited only at one side, i.e. the first side 11 (like in the ion implantation method) or on both sides of the wafer (first and second side 11, 12 like in a surface deposition method). In case of double sided applying, the dopant on the second side 12 is removed before diffusion, e.g. by etching or polishing, and then the dopant is driven-in only at the first side 11 or the dopant is diffused on both sides and the wafer is thinned on the second side 12 after diffusion as to completely remove the p doped layer created on the second side 12.

Exemplarily, cathode sided processes on the wafer are performed after finishing the diffusions for the anode layer 3. Such a cathode sided process can be the creation of an n-doped cathode layer 5, which has higher doping concentration than the drift layer 2 (FIG 9).

Metal layers for the cathode and anode electrode 4, 6 are exemplarily deposited on the cathode and anode side 40, 60 after finalizing all layers at the wafer 10. Alternatively, the anode electrode 40 may be created before the cathode sided process are performed (FIG 8). Then, the cathode layer 5 may be created (FIG 9) and finally, the cathode electrode 6 is created (FIG 10).

A metal layer as a cathode electrode 6 is arranged on top of the cathode layer 5 or on top of the drift layer 2, respectively, for a device without a cathode layer 25. A metal layer as an anode electrode 4 is arranged on the anode side 40 of the wafer. In the method disclosed in the description according to FIG 1 to 10, the anode layer 3 has been created as a continuous layer over the whole first side 11. All reference signs are the same as for the foregoing figures. In the following only additional manufacturing steps are explained.

In the figures 11 to 17, an another embodiment of the inventive manufacturing method is shown, in which additional steps are added. After step (a) and before step (b) a mask 8 is applied on the first side 11. The mask 8 has an opening at an inner region 7 and a plurality of openings in a termination region 70, which laterally surrounds the inner region 7 (FIG 11). The opening in the inner region 7 leaves the whole inner region 7 uncovered. The inner region 7 extends from the anode side 40 (first side 11) to the cathode side 60 (second side 12). The inner region 7 in the finalized diode 1 is such area, in which the anode electrode 4 contacts the anode layer 3, in particular the anode contact layer 36. The anode electrode 4 contacts the anode contact layer over the whole anode sided area of the inner region 7. That means that in the inner region, no mask is available and all dopants may be applied to the wafer 10. To the lateral sides of the wafer/diode, the inner region 7 is surrounded by the termination region 70, in which no contact of a doped layer to the anode electrode 4 is established.

The mask 8 has openings in the termination region 70, which may vary in width and/or in distance between the openings depending on the application needs. The layers created in the termination region 70 are exemplarily varied lateral doping (VLD) layers or p doped guard rings 75, optionally also in combination with termination extensions. Such layers are well-known to the persons skilled in the art. In such areas, in which the mask 8 is available (i.e. in which the mask has no opening) in the termination region 70, the first and second dopants 31, 34 are hindered from being applied to the wafer 10.

Guard rings 75 may have a constant width (extension of the guard ring in a direction of increasing distance from the inner region 7 (active cell area), i.e. in a plane parallel to the first side 11 and in a direction perpendicular to the border of the inner region 7). Alternatively, width and/or distance of such guard rings 75 (also called field rings) may vary. In FIG 17 the width of such guard rings 75 increases with increasing distance from the inner region 7 as well as the distance between the guard rings 75 increases. This results in p doped rings, which overlap closer to the inner region 7, whereas closer to the edge of the diode (i.e. with larger distances from the inner region 7), the guard rings 75 are separated from each other by the drift layer 2.

In an exemplary embodiment p doped guard rings 75 (i.e. rings enclosing the inner region 7, i.e. the active region of the diode) are surrounded by extension regions (also called junction termination extensions (JTE)), each extension region being formed as a p doped ring-shaped semiconductor region having a peak doping concentration lower than that of the floating field rings, each one of extension regions being formed on the lateral side of a corresponding floating ring to surround the corresponding floating field ring and to be in direct contact with the corresponding floating field ring. The extension region is farer away from the inner region 7 than the field ring to which it is connected. Each one of the extension regions extends from the first side surface to a depth which is deeper than the depth of the corresponding floating field ring. The extension regions reduce the electric field peak which can be observed at the pn-junction on the lateral side of the floating field ring facing away from the active region. Such a ring-shaped zone may again be surrounded by another zone, in which p doped guards rings are arranged (without extension regions), the p guard rings being separated from each other by the drift layer 2. Such an arrangement is advantageous for good SOA properties.

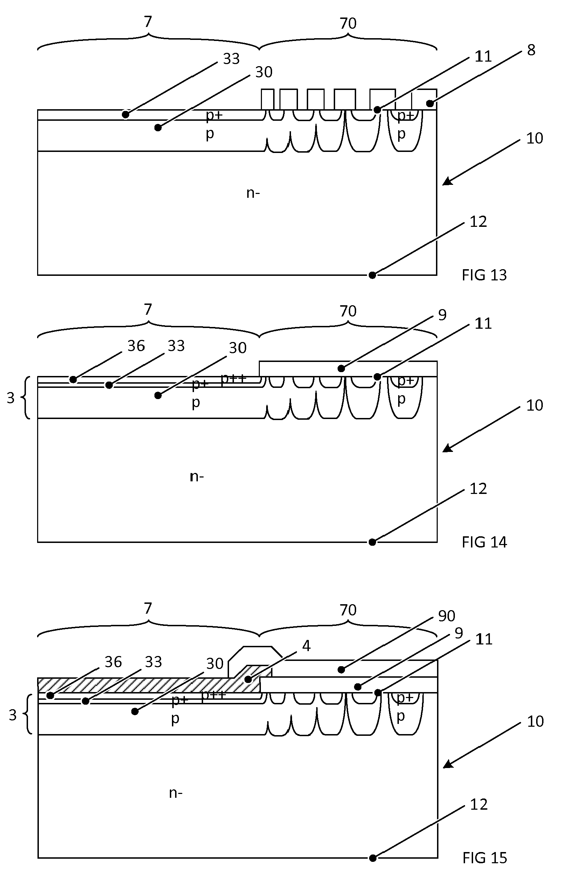

After having applied the mask 8, the first dopant 31 is applied and diffused (FIG 13) as step (b) and (c). Then, the second dopant 34 is applied and diffused (FIG 14) as step (d) and (e).

Now, before performing step (f), the mask 8 may be removed and a passivation layer 9 may be applied in the termination region 70 on the first side 11. The passivation layer 9 is a continuous layer covering the whole termination region 70 on the first side 11. The passivation layer 9 has such thickness that it acts as a mask for the following application of the third dopant 37 is step (f). Now, the third dopant 37 is applied in step (f) in the inner region 7, whereas in the termination region 70 the third dopant 37 is hindered from entering into the wafer 10 by the passivation layer 9. Then, in step (g) the third dopant 37 is diffused such that in the inner region 7 a staple of anode contact layer 36, anode shield layer 33 and anode buffer layer 30 is created, whereas in the termination layer only the anode shield layer 33 and anode buffer layer 30 have been created (FIG 15), i.e. in the termination region 70 no anode contact layer is created.Then, an anode electrode 4 applied on the anode contact layer 36 in the inner region 7, which contacts the anode contact layer 36. In the termination region 70, a further passivation layer may be applied, which covers the edges of the anode electrode 4 towards the termination region 70 and the passivation layer 9.

Afterwards, again an n doped cathode layer 5 may be created on the second side 12 (exemplarily by applying an n dopant and diffusing the n dopant or by epitaxial growth) (FIG 16) and a cathode electrode 6 may be applied on the second side 12 (if applicable on the cathode layer 5) (FIG 17).

Additionally to the creation of the inventive anode layer 3, a local defect layer may be created in a defect layer depth within the anode buffer layer by irradiation. Such a local defect layer introduces defects to the diode over a limited depth range, i.e. the local defect layer does not extend over the whole wafer in a direction from the cathode to the anode side 60, 40. Such a defect layer is an optional layer, which may be created at any manufacturing stage, even after the creation of the metal layers as electrodes 4, 6. The inventive diode achieves already good properties without such a local defect layer (also called life time control layer), but depending on the application it might be desired to introduce such a local defect layer. Light ions such as protons or helium or protons, electrons or heavy metal diffusion are exemplarily used for the creation of the local defect layer. The irradiation energy of these ions is chosen such that a defect layer is created with a defect peak, which is arranged in a depth beyond the anode contact layer and outside the space charge region so that the leakage current is not increased, which is exemplarily 8 $\mu$m, in particular 7 $\mu$m. Therefore, the defect layer is created in a defect layer depth of at most 8 $\mu$m, exemplarily between 3 and 7 $\mu$m.

By placing the defect layer between the crossing point of the anode buffer layer 30 and the anode shield layer 33, the doping concentration is comparatively low and therefore, the electron-hole plasma in the on-state can be significantly reduced. This improves the SOA of the diode and soft recovery can be achieved. Due to the slower drop of the doping concentration in the anode buffer layer 30 than in the anode shield layer 33, the process is less delicate to effects, which influence the depth of the local defect layer (like changes of the irradiation energy or to any coarseness of the surface of the wafer). At the same time, the local defect layer is placed into a region which is not reached by the space charge region (SCR) of the anode junction at breakdown voltage. Thereby, the leakage current can be kept low. By keeping the peak of the defect centers at a smaller depth than the depth of the SCR the radiation defects do not increase the leakage current, because they are not present at the SCR. Local lifetime control can be achieved due to the presence of the defect centers without enhancing the leakage current. Thereby, the diode can be operated at higher temperatures.

Additionally or alternatively, an electron irradiation may be applied to the whole diode (i.e. over the whole device thickness), by which an overall lifetime control is achieved, which modifies the full plasma.

The inventive diode may optionally have edge terminations known from prior art like positive bevels, which means that the diode 1 has a smaller width at the cathode side 60 than at the anode side 40, or negative bevels, which means that the diode 1 has a larger width at the cathode side 60 than at the anode side 40. The width of the device is the distance between the lateral sides of the device, whereas the lateral sides are the sides between the cathode side 60 and the anode side 40.

For devices with a positive or negative bevel, there is an angle of the lateral side of a wafer, which side is arranged between the cathode and the anode side, which angle is different from 90°. In case of a positive bevel, the angle measured from the cathode side 60 inside the silicon is larger than 90°, for a negative bevel, the angle measured inside the silicon is larger than 90° when measured at the anode side. With a negative bevel, the electric field can be reduced on the bevel over a great length due a small doping concentration gradient, which gives advantages in the increased static blocking for the device. This effect is further enhanced by the inventive doping profile. The advantages of the bevel termination is the easy manufacturing of discrete diodes and lower leakage current compared to the guard rings and VLD.

These examples shall not limit the scope of the invention. The above mentioned designs and arrangements are just examples for any kinds of possible designs and arrangements of the triple anode layer.

It should be noted that the term "comprising" does not exclude other elements or steps and that the indefinite article "a" or "an" does not exclude the plural. Also elements described in association with different embodiments may be combined. It should also be noted that reference signs in the claims shall not be construed as limiting the scope of the claims.

It will be appreciated by those skilled in the art that the present invention can be embodied in other specific forms without departing from the spirit or essential characteristics thereof. The presently disclosed embodiments are therefore considered in all respects to be illustrative and not restricted. The scope of the invention is indicated by the appended claims rather than the foregoing description and all changes that come within the meaning and range and equivalence thereof are intended to be embraced therein.

*Reference List*

| 1 | diode |
|---|---|
| 10 | wafer |
| 11 | first side |
| 12 | second side |
| 13 | cathode side |
| 14 | anode side |
| 2 | drift layer |
| 3 | anode layer |
| 30 | anode buffer layer |
| 31 | first dopant |
| 32 | anode buffer layer depth |
| 33 | anode shield layer |
| 34 | second dopant |
| 35 | anode shield layer depth |
| 36 | anode contact layer |
| 37 | third dopant |
| 38 | anode contact layer depth |
| 4 | anode electrode |
| 40 | anode side |
| 5 | cathode layer |
| 6 | cathode electrode |
| 60 | cathode side |
| 7 | inner region |
| 70 | termination region |
| 75 | guard ring |
| 8 | mask |
| 9 | passivation layer |
| 90 | further passivation layer |

**Claims**

1. A method for manufacturing a bipolar diode (1) having a drift layer (2) of a first conductivity type on a cathode side (60) and an anode layer (3) of a second conductivity type on an anode side (40) opposite to the cathode side (60), which anode layer (3) comprises an anode contact layer (36), an anode shield layer (33) and an anode buffer layer (30), the method comprising the following manufacturing steps in the following order:

    (a) providing a wafer (10) of the first conductivity type, which wafer (10) has a first side (11) and a second side (12) opposite to the first side (11), wherein such part of the wafer of unamended doping concentration in the finalized diode forming the drift layer (2),
    (b) applying a first dopant (31) of the second conductivity type to the wafer (10) on the first side (11),
    (c) creating the anode buffer layer (30) by diffusing the first dopant (31) into the wafer (10) at a first temperature up to an anode buffer layer depth (32), which is between 15 and 30 $\mu$m,
    (d) applying a second dopant (34) of the second conductivity type to the wafer (10) on the first side (11),
    (e) creating the anode shield layer (33) by diffusing the second dopant (34) into the wafer (10) at a second temperature, which is lower than the first temperature, and up to an anode shield layer depth (35), which is up to 3 $\mu$m,
    (f) applying a third dopant (37) of the second conductivity type to the wafer (10) on the first side (11), and
    (g) creating the anode contact layer (36) by diffusing the third dopant (37) into the wafer (10) at a third temperature, which is lower than the second temperature, and up to an anode contact layer depth (38), which is up to 0.5 $\mu$m,

    wherein a maximum doping concentration of the anode contact layer (36) is higher than a maximum doping concentration of the anode shield layer (33), which is higher than a maximum doping concentration of the anode buffer layer (30).

2. The method according to claim 1, comprising diffusing the first dopant (31) in step (c) such that the anode buffer layer (30) has the maximum doping concentration below $2.0*10^{16}$ cm$^{-3}$ at the crossing point to the anode shield layer (33).

3. The method according to any of the claims 1 or 2, **characterized in, that** diffusing the second dopant (34) in step (e) such that the anode shield layer (33) has the maximum doping concentration between $2.0*10^{16}$ cm$^{-3}$ and $1.0*10^{17}$ cm$^{-3}$ at the crossing point to the anode contact layer (36).

4. The method according to any of the claims 1 to 3, **characterized in, that** diffusing the third dopant (37) in step (g) such that the anode contact layer (36) has the maximum doping concentration of at least $1.0*10^{17}$ cm$^{-3}$.

5. The method according to any of the claims 1 to 4, **characterized in, that** a diffusion time for the first dopant in step (c) is longer than a diffusion time for the second dopant in step (e), which is longer than a diffusion time for the third dopant in step (g).

**6.** The method according to any of the claims 1 to 5, **characterized in, that** applying the same dopant as the first dopant (31) in step (b) and the second dopant (34) in step (d) and the third dopant (37) in step (f).

**7.** The method according to any of the claims 1 to 6, **characterized in, that** applying Boron, Aluminum or Gallium as the first, second or third dopant (31, 34, 37) or a combination of these dopants (31, 34, 37).

**8.** The method according to any of the claims 1 to 7, **characterized in, that** the diode (1) comprises an inner region (7), in which the anode contact layer (36) contacts an anode electrode (4), and a termination region (70), which laterally surrounds the inner region (7),
wherein after step (a) and before step (b) a mask (8) is applied on the first side (11), which has an opening in the inner region (7) and a plurality of openings in the termination region (70), thereby preventing the dopants from being applied in the termination region (70) in such areas, in which the mask has been applied on.

**9.** A bipolar diode (1) having a drift layer (2) of a first conductivity type on a cathode side (60) and an anode layer (3) of a second conductivity type on an anode side (40) opposite to the cathode side (60), which anode layer (3) comprises an anode contact layer (36), an anode shield layer (33) and an anode buffer layer (30),
wherein the anode buffer layer (30) is arranged up to an anode buffer layer depth (32) between 15 and 30 $\mu$m,
wherein the anode shield layer (33) is arranged up to an anode shield layer depth (35), which is up to 3 $\mu$m,
wherein the anode contact layer (36) is arranged up to an anode contact layer depth (38), which is up to 0.5 $\mu$m,
wherein a maximum doping concentration of the anode contact layer (36) is higher than a maximum doping concentration of the anode shield layer (33), which is higher than a maximum doping concentration of the anode buffer layer (30).

**10.** The diode (1) according to claim 9, **characterized in, that** the anode buffer layer (30) has the maximum doping concentration below $2.0*10^{16}$ cm$^{-3}$ at the crossing point to the anode shield layer (33).

**11.** The diode (1) according to any of claims 9 or 10, **characterized in, that** the anode shield layer (33) has the maximum doping concentration between $2.0*10^{16}$ cm$^{-3}$ and $1.0*10^{17}$ cm$^{-3}$ at the crossing point to the anode contact layer (36).

**12.** The diode (1) according to any of claims 9 or 11, **characterized in, that** the anode contact layer (36) has the maximum doping concentration of at least $1.0*10^{17}$ cm$^{-3}$.

**13.** The diode (1) according to any of claims 9 or 12, **characterized in, that** the diode (1) comprises an inner region (7), in which the anode contact layer (36) contacts an anode electrode (4), and a termination region (70), which laterally surrounds the inner region (7),
wherein in the inner region (7) the anode layer (3) consists of the anode contact layer (36), the anode shield layer (33) and the anode buffer layer (30), and wherein in the termination region (70) the anode layer (3) consists of the anode shield layer (33) and the anode buffer layer (30).

11

n-

10

12

FIG 1

31  11

n-

10

12

FIG 2

30  11  32

↓↓↓↓↓↓↓↓↓↓↓↓↓↓↓↓↓↓↓↓↓↓

10

n-

12

FIG 3

34  11
30  32

p

10

n-

12

FIG 4

33  35  30  11  32  10  12

FIG 5

37  33  35  30  11  32  10  12

p+
p

FIG 6

36  38  33  35  30  11  32  10  12

3

p+
p

FIG 7

4  36  38  33  35  30  11  32  10  12

3

p+  p++
p

FIG 8

FIG 9

FIG 10

FIG 11

FIG 12

7 70

33
30
11
8

p+
p

n-

10

12

FIG 13

7 70

36 33 30
9
11

3

p+ p++
p

p+
p

n-

10

12

FIG 14

7 70

90
9
11

36 33 30
4

3

p+ p++
p

p+
p

n-

10

12

FIG 15

FIG 16

FIG 17

FIG 18

**Europäisches Patentamt**
**European Patent Office**
**Office européen des brevets**

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 103 178 120 A (MACMIC SCIENCE & TECHNOLOGY CO LTD) 26 June 2013 (2013-06-26) * paragraph [0008] - paragraph [0087]; figures 1-13 * ----- | 1-7,9-12 | INV. H01L29/36 H01L29/66 H01L29/861 |
| A | EP 2 320 452 A1 (ABB TECHNOLOGY AG [CH]) 11 May 2011 (2011-05-11) * paragraph [0007] - paragraph [0037]; figures 1-8 * ----- | 1-7,9-12 | |

**TECHNICAL FIELDS SEARCHED (IPC)**

H01L

~~The present search report has been drawn up for all claims~~

| Place of search | Date of completion of the search | Examiner |
|---|---|---|
| Munich | 8 July 2016 | Norga, Gerd |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons
 
& : member of the same patent family, corresponding
      document

EPO FORM 1503 03.82 (P04C01)

Europäisches
Patentamt

European
Patent Office

Office européen
des brevets

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-7, 9-12

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

Application Number

EP 16 15 2366

The Search Division considers that the present European patent application does not comply with the requirements of unity of invention and relates to several inventions or groups of inventions, namely:

1. claims: 1-7, 9-12

   A method for manufacturing a bipolar diode having a drift layer of a first conductivity type on a cathode side and an anode layer of a second conductivity type on an anode side opposite to the cathode side, which anode layer comprises an anode contact layer, an anode shield layer and an anode buffer layer, the method comprising the following manufacturing steps in the following order:(a) providing a wafer of the first conductivity type, which wafer has a first side and a second side opposite to the first side, wherein such part of the wafer of unamended doping concentration in the finalized diode forming the drift layer,(b) applying a first dopant of the second conductivity type to the wafer on the first side,(c) creating the anode buffer layer by diffusing the first dopant into the wafer at a first temperature up to an anode buffer layer depth, which is between 15 and 30 pm,(d) applying a second dopant of the second conductivity type to the wafer on the first side,(e) creating the anode shield layer by diffusing the second dopant into the wafer at a second temperature, which is lower than the first temperature, and up to an anode shield layer depth, which is up to 3 ?m,(f) applying a third dopant of the second conductivity type to the wafer on the first side, and(g) creating the anode contact layer by diffusing the third dopant into the wafer at a third temperature, which is lower than the second temperature, and up to an anode contact layer depth, which is up to 0.5 pm,wherein a maximum doping concentration of the anode contact layer is higher than a maximum doping concentration of the anode shield layer, which is higher than a maximum doping concentration of the anode buffer layer, wherein the second dopant in step (e) is diffused such that the anode shield layer has the maximum doping concentration between $2.0*10^{16}$ cm-3 and $1.0*10^{17}$ cm-3 at the crossing point to the anode contact layer.

   ---

2. claims: 8, 13

   A method for manufacturing a bipolar diode having a drift layer of a first conductivity type on a cathode side and an anode layer of a second conductivity type on an anode side opposite to the cathode side, which anode layer comprises an anode contact layer, an anode shield layer and an anode buffer layer, the method comprising the following manufacturing steps in the following order:(a) providing a wafer of the first conductivity type, which wafer has a first side and a second side opposite to the first side, wherein such part of the wafer of unamended doping concentration in the finalized diode forming the drift

Europäisches
Patentamt

European
Patent Office

Office européen
des brevets

**LACK OF UNITY OF INVENTION
SHEET B**

Application Number

EP 16 15 2366

The Search Division considers that the present European patent application does not comply with the requirements of unity of invention and relates to several inventions or groups of inventions, namely:

layer,(b) applying a first dopant of the second conductivity type to the wafer on the first side,(c) creating the anode buffer layer by diffusing the first dopant into the wafer at a first temperature up to an anode buffer layer depth, which is between 15 and 30 pm,(d) applying a second dopant of the second conductivity type to the wafer on the first side,(e) creating the anode shield layer by diffusing the second dopant into the wafer at a second temperature, which is lower than the first temperature, and up to an anode shield layer depth, which is up to 3 ?m,(f) applying a third dopant of the second conductivity type to the wafer on the first side, and(g) creating the anode contact layer by diffusing the third dopant into the wafer at a third temperature, which is lower than the second temperature, and up to an anode contact layer depth, which is up to 0.5 pm, wherein a maximum doping concentration of the anode contact layer is higher than a maximum doping concentration of the anode shield layer, which is higher than a maximum doping concentration of the anode buffer layer, whereby the diode comprises an inner region, in which the anode contact layer contacts an anode electrode, and a termination region, which laterally surrounds the inner region,wherein after step (a) and before step (b) a mask is applied on the first side, which has an opening in the inner region and a plurality of openings in the termination region, thereby preventing the dopants from being applied in the termination region in such areas, in which the mask has been applied on.
---

page 2 of 2

## ANNEX TO THE EUROPEAN SEARCH REPORT
## ON EUROPEAN PATENT APPLICATION NO.

EP 16 15 2366

This annex lists the patent family members relating to the patent documents cited in the above-mentioned European search report.
The members are as contained in the European Patent Office EDP file on
The European Patent Office is in no way liable for these particulars which are merely given for the purpose of information.

08-07-2016

| Patent document cited in search report | | Publication date | Patent family member(s) | | Publication date |
|---|---|---|---|---|---|
| CN 103178120 | A | 26-06-2013 | NONE | | |
| EP 2320452 | A1 | 11-05-2011 | AT | 529888 T | 15-11-2011 |
| | | | CN | 102074586 A | 25-05-2011 |
| | | | EP | 2320452 A1 | 11-05-2011 |
| | | | ES | 2374901 T3 | 23-02-2012 |
| | | | JP | 5769950 B2 | 26-08-2015 |
| | | | JP | 2011101021 A | 19-05-2011 |
| | | | US | 2011108953 A1 | 12-05-2011 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2535940 A1